(19) Europäisches Patentamt / European Patent Office / Office européen des brevets

(11) **EP 3 806 492 B1**

(12) **EUROPEAN PATENT SPECIFICATION**

(45) Date of publication and mention
of the grant of the patent:
**04.09.2024  Bulletin 2024/36**

(21) Application number: **20200820.7**

(22) Date of filing: **08.10.2020**

(51) International Patent Classification (IPC):
*H04R 9/02* *(2006.01)*      *H04R 9/06* *(2006.01)*
*H05K 7/20* *(2006.01)*

(52) Cooperative Patent Classification (CPC):
**H05K 7/20509; H04R 9/022; H04R 9/06**

(54) **PASSIVE THERMAL-CONTROL SYSTEM OF A MESH NETWORK DEVICE AND ASSOCIATED MESH NETWORK DEVICES**

PASSIVES THERMISCHES STEUERUNGSSYSTEM EINER MESH-NETZWERKVORRICHTUNG UND ZUGEHÖRIGE MESH-NETZWERKVORRICHTUNGEN

SYSTÈME DE CONTRÔLE THERMIQUE PASSIF D'UN DISPOSITIF DE RÉSEAU MAILLÉ ET DISPOSITIFS DE RÉSEAU MAILLÉ ASSOCIÉS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **10.10.2019   US 201962913342 P**
**06.10.2020   US 202017064372**

(43) Date of publication of application:
**14.04.2021   Bulletin 2021/15**

(73) Proprietor: **Google LLC**
**Mountain View, CA 94043 (US)**

(72) Inventors:
• **Heckmann, Frédéric**
**Mountain View, CA California 94043 (US)**
• **Ihab, Ali**
**Mountain View, CA California 94043 (US)**

(74) Representative: **Maikowski & Ninnemann**
**Patentanwälte Partnerschaft mbB**
**Postfach 15 09 20**
**10671 Berlin (DE)**

(56) References cited:
**US-A1- 2015 382 448      US-A1- 2019 104 640**

EP 3 806 492 B1

## Description

### TECHNICAL FIELD

The present specification relates to embodiments of an apparatus including a speaker module and a passive thermal-control system.

### BACKGROUND

A mesh network is a network that includes multiple nodes that link together to improve network performance and network accessibility. As an example, a mesh network supporting a wireless local area network (WLAN) may include multiple wireless nodes linking together across an area. Each wireless node, or mesh network device, may provide wireless devices access to the WLAN and exchange network information with other mesh network devices. The aggregate functions of the multiple mesh network devices, in general, improve connectivity to the WLAN across the area and improve efficiency of data exchange.

In some instances, the mesh network device may be a range-extending mesh network device that includes a voice assistant. The mesh network device may be a small form-factor and include multiple electronic subsystems that generate heat. An example of an electronic subsystem is a printed circuit board (PCB) that is populated with a variety of integrated circuit (IC) devices. Another example of an electronic subsystem is a speaker module that may be used by the voice assistant.

To dissipate heat from the electronic subsystems and avoid degradation of the electronic subsystems, a thermal-control system may be used. However, an active thermal-control system, such as a thermal-control system that circulates a coolant or a liquid, may not be feasible due to form-factor and/or power consumption considerations.

US 2015/382448 A1 relates to system-in-package assemblies in portable electronic devices. US 2019/104640 A1 relates to a mid-spreader for stacked circuit boards in an electronic device.

### SUMMARY

The invention is defined by independent claim 1. Features of exemplary embodiments are defined in the dependent claims.

### BRIEF DESCRIPTION OF THE DRAWINGS

The details of one or more aspects of a passive thermal-control system for a mesh network device and associated mesh network devices are described below. The use of the same reference numbers in different instances in the description and the figures may indicate like elements:

FIG. 1 illustrates an example operating environment including a mesh network device having a passive thermal-control system.
FIG. 2 illustrates a top isometric view of an example heat sink that may be included in a mesh network device.
FIG. 3 illustrates a bottom isometric view of an example heat sink that may be included in a mesh network device.
FIG. 4 illustrates a top isometric view of an example speaker-module subassembly that may be included in a mesh network device.
FIG. 5 illustrates a top plan view of an example PCB that may be included in a mesh network device.
FIG. 6 illustrates a bottom plan view of an example PCB that may be included in a mesh network device.
FIG. 7 illustrates an isometric view of example arrangements of thermal interface materials (TIMs) that may be included in a mesh network device.
FIG. 8 illustrates details of example heat flow paths within an example mesh network device.

### DETAILED DESCRIPTION

This document describes a passive thermal-control system that is integrated into a mesh network device. The passive thermal-control system, which may include a heat sink and multiple heat spreaders, is structured such that heat originating from IC devices of the mesh network device and a speaker module of the mesh network device may be transferred to other components of the mesh network device, such as a housing component. The heat may then be dissipated to an external environment to maintain a desired thermal profile of the mesh network device.

Heat transfer, in general, is energy that is in transit due to a temperature difference. If one or more temperature differences exist across components of a system, such as the mesh network device, heat (e.g., energy in Joules (J)) will transfer from higher temperature zones to lower temperature zones to reduce the temperature differences. There are several mechanisms for heat transfer across the components of the system to reduce temperature differences, including convection, radiation, and conduction.

Convection, or heat transfer from a surface due to movement of molecules within fluids such as gases and liquids, may be quantified by equation (1) below:

$$q_{conv} = hA \ (T_s - T_\infty) \qquad (1)$$

For equation (1), $q_{conv}$ represents a rate of heat transfer from a surface through convection (*e.g.*, in J per second or Watts (W)), $h$ represents a convection heat-transfer coefficient (*e.g.*, in W per meter squared (W/m$^2$)), $T_s$ represents a temperature of a surface (*e.g.*, in Kelvin (K) or degrees Celsius (°C)), and $T_\infty$ represents a temperature of a fluid (*e.g.*, in K or °C) to which the surface is exposed. The term $A$ represents an area of a surface (*e.g.*, in m$^2$).

Radiation, or heat transfer from a surface through electromagnetic radiation, may be quantified by equation (2) below:

$$q_{rad} = \varepsilon A \sigma \ (T_s^4 - T_{surr}^4) \qquad (2)$$

For equation (2), $q_{rad}$ represents a rate of heat transfer through radiation (*e.g.*, in W), $\varepsilon$ represents emissivity (dimensionless), $\sigma$ represents the *Stefen-Boltzmann* constant (*e.g.*, $\sigma = 5.67 \times 10^{-8}$ W/(m$^2$·K$^4$)), $T_s$ represents a temperature of a surface *(e.g.*, in K or °C), and $T_{surr}$ represents a temperature of surroundings of the surface (*e.g.*, in K or °C). The term $A$ represents an area of the surface (*e.g.*, in m$^2$).

Conduction, or heat transfer through a solid body through atomic and molecular activity, may be quantified by equation (3) below:

$$q_{cond} = -kA\frac{dT}{dx} \qquad (3)$$

For equation (3), $q_{cond}$ represents a rate of heat transfer in a solid material through conduction (e.g., in W), k represents a thermal conductivity of the solid material *(e.g.,* in W/(m·K)), and $dT/dx$ represents a temperature gradient through the solid material (e.g., in K/m or °C/m). The term A represents a cross-sectional area of the solid material (e.g., in m$^2$).

In instances of heat transfer from one physical body to another, through one or more of a convection heat-transfer mechanism, a radiation heat-transfer mechanism, or a conduction heat-transfer mechanism, the physical bodies may be in thermal contact. In some instances, this can include direct physical contact between the bodies or a material (*e.g.*, a TIM) located between the bodies, enabling conduction-based heat transfer between the bodies. In other instances, this can include an air gap between the bodies that enables convection-based and/or radiation-based heat transfer between the bodies.

A mesh network device includes a passive thermal-control system that, e.g., transfers heat using one or more of the heat-transfer mechanisms described above. In general, and in accordance with equations (1) and (2), rates and/or quantities of heat transfer can be varied by increasing or decreasing surface areas for convection and/or radiation within the mesh network device (*e.g.*, increasing or decreasing surface areas of planar heat spreaders). In accordance with equation (3) and within the passive thermal-control system, rates and/or quantities of heat transfer can also be varied by introducing, between surfaces, one or more thermal interface materials (TIMs) that have a high thermal conductivity.

Through conduction, convection, and radiation heat-transfer mechanisms, as described and quantified by equations (1) - (3) above, the passive thermal-control system may transfer heat originating from heat-generating electronic devices within the mesh network device to an interior surface of a housing component of the mesh network device. An exterior surface of the housing component may then dissipate the heat to an external environment through convection and/or radiation, effective to prevent degradation of the electronic subsystems that may include the heat-generating electronic devices.

While features and concepts of the described passive thermal-control system can be implemented in any number of different environments, apparatuses, and/or various configurations, aspects are described in the context of the following examples.

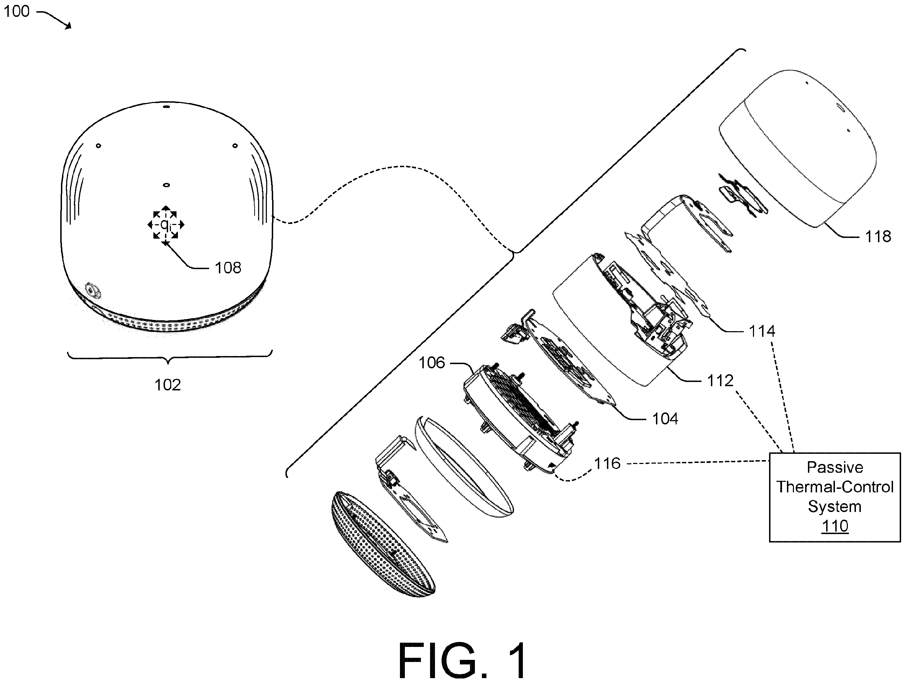

FIG. 1 illustrates an example operating environment 100 including a mesh network device 102. The mesh network device 102 includes multiple electronic devices, including a PCB 104 populated with one or more IC devices. The mesh network device 102 also includes a speaker module 106.

The mesh network device 102 may serve as a node of a wireless mesh network (e.g., a WLAN network conforming to IEEE 802.11 communication protocols (Wi-Fi)). In general, the mesh network device 102 may wirelessly couple other wireless devices (*e.g.,* a wireless phone, a laptop computer) to the wireless mesh network.

The mesh network device 102 may, in some instances, include a voice-assistant to receive audible inputs from a user of the mesh network device 102. For example, the mesh network device 102 may receive, through the speaker module 106 and from a user of the mesh network device 102, a vocal command that the mesh network device 102 transmits to one or more applications available through the wireless mesh network (*e.g.,* available from a cloud-computing environment or available through another device to which the mesh network device 102 is wirelessly coupled). As an example, the vocal command may be transmitted to a remote application supporting a home automation or security system.

As another example, the mesh network device 102 may receive, through the speaker module and from the user of the mesh network device 102, a vocal query. The mesh network device 102 may transmit the vocal query to one or more other applications available through the wireless mesh network (e.g., available from a cloud-computing environment or available through another device to which the mesh network device 102 is wirelessly coupled). In some instances, the vocal query may direct a search to be performed by a search engine available through the wireless mesh network. In other instances, the vocal query may direct media to be streamed through the speaker module 106 of the mesh network device 102 (e.g., play music through the mesh network device 102).

In general, and while performing operations (e.g., wirelessly coupling the other devices, receiving vocal commands, receiving vocal queries, playing media), the one or more IC devices populated on the PCB 104 and the speaker module 106 may generate an internal heat load 108 within the mesh network device 102. To manage the internal heat load 108 within the mesh network device 102 (e.g., prevent thermal runaway or damage to electronic systems of the mesh network device 102), a passive thermal-control system 110 is used.

The passive thermal-control system 110 includes multiple elements, including a heat sink 112, a heat-sink heat spreader 114, and a speaker-module heat spreader 116 (not visible in FIG. 1). In some instances, the passive thermal-control system 110 may also include multiple thermal interface materials (TIMs).

The heat sink 112 is generally cylindrical in shape, die-cast from a metal material (e.g., an aluminum material, a magnesium material). The heat-sink heat spreader 114 and the speaker-module heat spreader 116 each may be generally elliptical (or generally circular) in shape. The heat-sink heat spreader 114 and the speaker-module heat spreader 116 each are also generally planar, formed from respective sheets of a graphite material.

The elements of the passive thermal-control system 110 (e.g., the heat sink 112, the heat-sink heat spreader 114, the speaker-module heat spreader 116) conduct, spread, and transfer the internal heat load 108 *(e.g.,* a rate of heat transfer $q_i$ in Watts) to a housing component 118 of the mesh network device 102 or to a base 120 of the mesh network device. The housing component(s) 118 may then dissipate the internal heat load 108 (e.g., using a thermal-convection heat-transfer mechanism and/or a thermal-radiation heat-transfer mechanism) to an external environment. In some instances, and depending on configurations of the passive thermal-control system 110, portions of the internal heat load 108 transferred to the housing component(s) 118 may vary.

The passive thermal-control system 110 further maintains a desired thermal profile of the mesh network device 102. As an example, the conduction, spreading, and transfer of the internal heat load 108 by the passive thermal-control system 110 may maintain a surface temperature of the housing component(s) 118 at or below a temperature of approximately 67° Celsius (°C) while the mesh network device 102 is operating in ambient conditions of 25 °C. The passive thermal-control system 110 may also maintain junction temperatures of the IC devices populating the PCB 104 at or below different respective temperature thresholds.

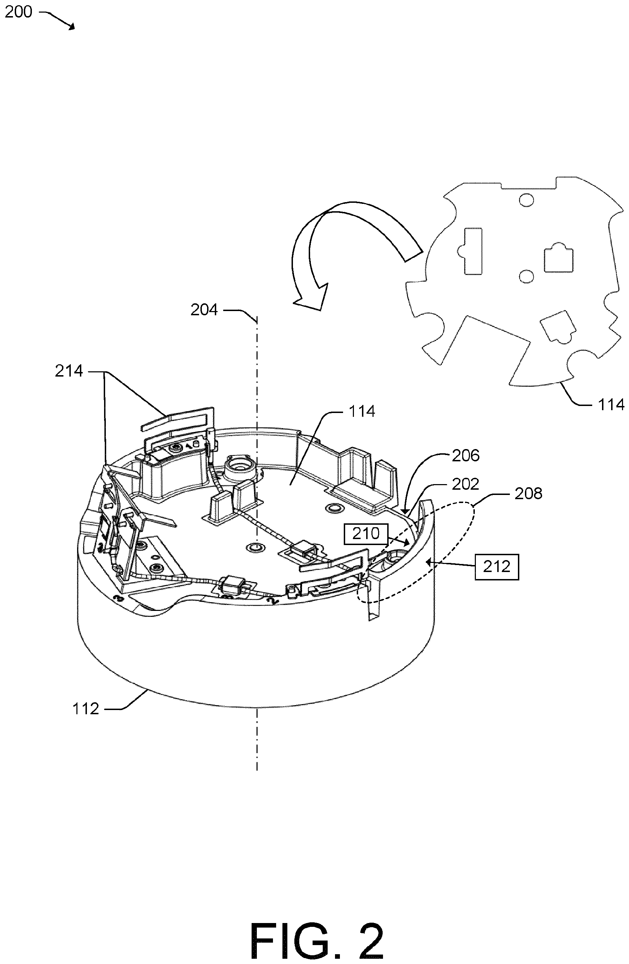

FIG. 2 illustrates a top isometric view 200 of an example heat sink and an example heat-sink heat spreader (e.g., the heat sink 112 and the heat-sink heat spreader 114 of FIG. 1). As illustrated, the heat sink 112 includes a body 202 that is generally disk-like (e.g., middle region of the heat sink 112) extending radially from a central axis 204 to define a perimeter. The body 202 includes a first generally planar surface 206 (located under the heat-sink heat spreader 114 in FIG. 2) that is substantially orthogonal to the central axis 204. The heat-sink heat spreader 114 attaches to the first generally planar surface 206 (*e.g.,* using a thermally conductive epoxy). Further, the heat-sink heat spreader 114 may be positioned coaxially with the heat sink 112, according to the central axis 204.

In some instances, the heat-sink heat spreader 114 may spread and transfer heat to the body 202 using a thermal-conduction heat-transfer mechanism. In other instances, the heat-sink heat spreader 114 may spread and transfer heat to a surrounding environment (*e.g.,* a cavity within the mesh network device 102 of FIG. 1) using a thermal-convection heat-transfer mechanism and/or a thermal-radiation heat-transfer mechanism. For example, the heat-sink heat spreader 114 may spread and transfer heat in a generally outward direction away from the first generally planar surface 206 of the body 202 of the heat sink 112.

The heat-sink heat spreader 114 may include one or more sheets (e.g., layers) of a thermally conductive material such as a graphite material. Furthermore, different types of materials may be selected to increase or decrease emissivity ($\varepsilon$) and alter thermal radiation characteristics of the heat-sink heat spreader 114.

The heat sink 112 may include one or more fin region(s) 208. Each fin region 208 may extend from the perimeter of the body 202 in one or more directions that are substantially parallel to the central axis 204. Furthermore, each fin region 208 may include an interior surface 210 and an opposing exterior surface 212. In some instances, each fin region 208 may transfer heat to a surrounding environment (e.g., to a cavity within the mesh network device 102 of FIG. 1 or to the housing component(s) 118 of the mesh network device of FIG. 1) using one or more of a thermal conduction, a thermal convection, and/or a thermal-radiation heat-transfer mechanism. The heat sink 112 may also include mounts, stands, or other fixturing mechanisms for one or more antenna(s) 214 that support wireless communications.

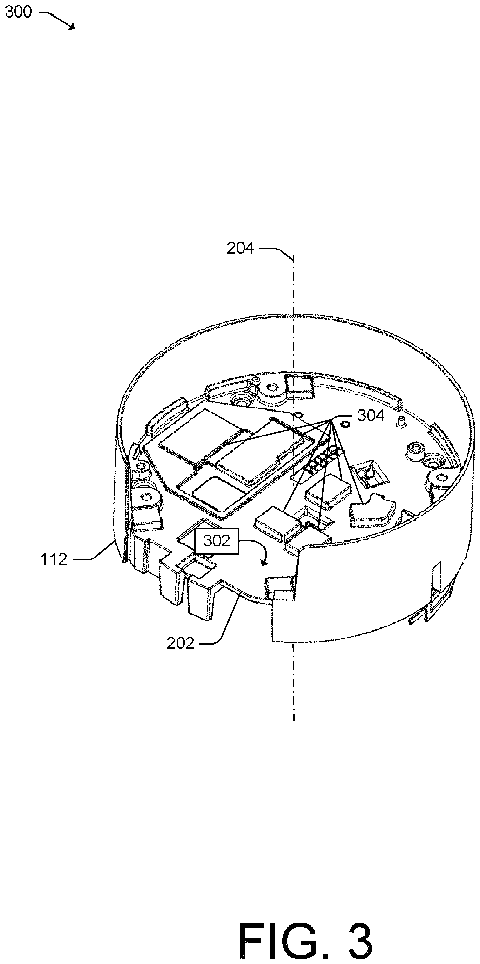

FIG. 3 illustrates a bottom isometric view 300 of an example heat sink (e.g., the heat sink 112 of FIG. 1). As illustrated, the body 202 of the heat sink 112 includes a second generally planar surface (e.g., second generally planar surface 302 that is opposite the first generally planar surface 206 of FIG. 1). The second generally planar surface 302 may be generally orthogonal to the central axis 204. Furthermore, the second generally planar surface may face a speaker module (e.g., the speaker module 106).

As illustrated, the body 202 includes one or more pedestal(s) 304 that protrude from the second generally planar surface 302. Each pedestal 304 may interface with a thermal interface material (TIM) and enable the TIM to make physical (and thermally conductive) contact with a respective, heat-generating device (e.g., an IC device that may be part of the PCB 104 of FIG. 1). The TIM may effectuate thermal coupling between the heat-generating device and the pedestal 304. The pedestal 304 may, in turn, and using a thermal-conduction heat-transfer mechanism, transfer heat to the body 202 of the heat sink 112.

Examples of TIMs include gel materials and/or grease materials that may be thermally conductive. These materials may be injected with nano-particles, such as magnesium or aluminum nano-particles, to improve thermal conduction properties. Furthermore, TIMs located between the heat-generating devices and the one or more pedestal(s) 304 may reduce gaps and/or bond line gaps and improve thermal conduction efficiencies. Other examples of TIMs include thermally conductive foam materials and thermally conductive pad materials.

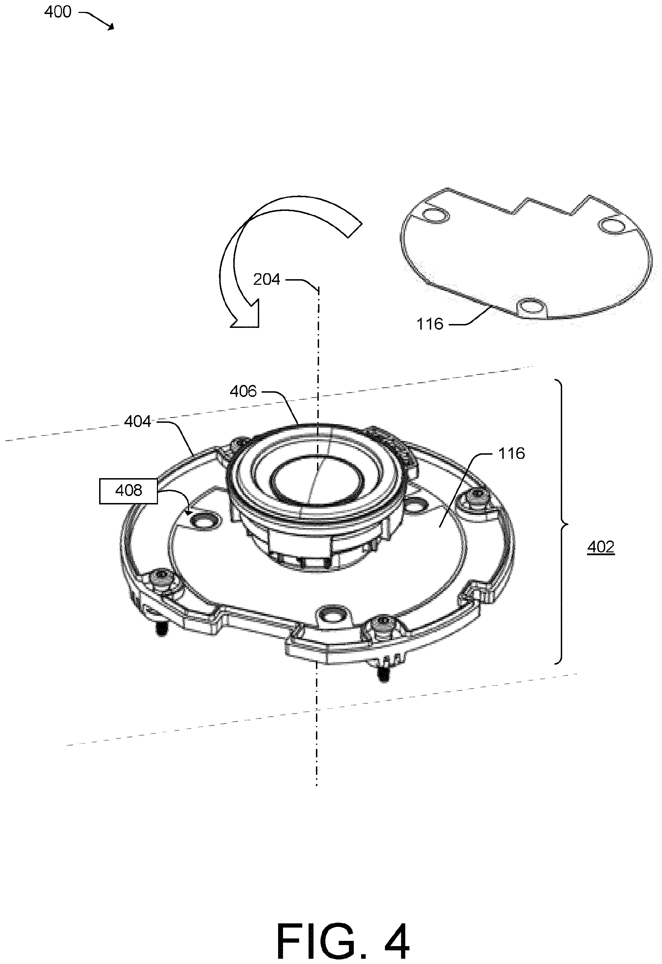

FIG. 4 illustrates a top isometric view 400 of an example speaker-module subassembly 402 that may be included in a mesh network device (e.g., the speaker-module subassembly 402 may be part of the speaker module 106 of the mesh network device 102 of FIG. 1). As illustrated, the speaker-module subassembly 402 includes a base 404 and a speaker-module driver 406. The base 404 includes an interior surface 408 that is generally planar and substantially orthogonal to the central axis 204. The interior surface 408 faces a second surface of a heat sink (e.g., the second generally planar surface 302).

As illustrated, a heat spreader (e.g., the speaker-module heat spreader 116 of FIG. 1) attaches to the interior surface 408 of the base 404. For example, the speaker-module heat spreader 116 may attach to the interior surface 408 using a thermally conductive epoxy. In some instances, the interior surface 408 may face a surface of a heat sink (e.g., the second generally planar surface 302 of FIG. 2).

In some instances, the speaker-module heat spreader 116 may be located between the interior surface 408 and a magnet of the speaker-module driver 406. The speaker-module heat spreader 116 may use a thermal-conduction heat-transfer mechanism to transfer heat from the speaker-module driver 406 to the base 404. In some instances, the base 404 may use thermal conduction and/or thermal convection heat-transfer mechanisms to transfer the heat to a surrounding environment.

The speaker-module heat spreader 116 may include one or more sheets (e.g., layers) of a thermally conductive material such as a graphite material. Furthermore, different types of materials may be selected to increase or decrease emissivity ($\varepsilon$) and alter thermal radiation characteristics of the speaker-module heat spreader 116.

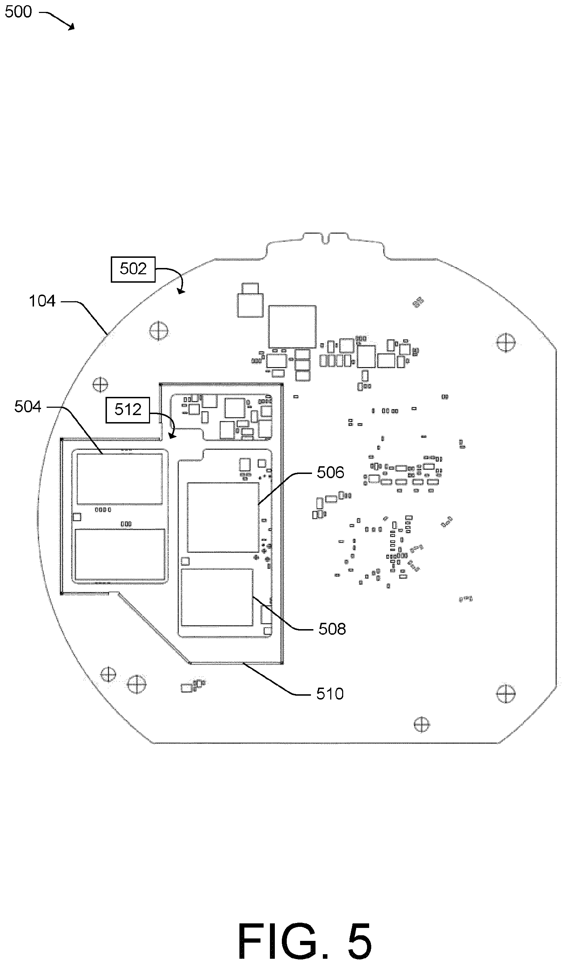

FIG. 5 illustrates a top plan view 500 of an example PCB that may be included in a mesh network device (e.g., the PCB 104 of the mesh network device 102 of FIG. 1). The PCB 104 may be a multi-layer PCB that includes a glass-reinforced epoxy laminate material (e.g., FR-4) and multiple layers of electrically conductive traces. The PCB 104 may also be a "double-sided" PCB, where different IC devices may be mounted to opposing surfaces of the PCB 104 using surface-mount (SMT) soldering techniques. In some instances, traces within the multiple layers of the PCB 104 may include a thermally conductive material. For example, traces within the multiple layers of the PCB 104 may include a copper material. The PCB 104 may also include one or more ground planes (e.g., copper ground planes) that may each absorb, spread, and transfer heat within the PCB 104.

A first surface of the PCB 104 (e.g., a first surface 502) may be populated with a first set of IC devices. The first set of IC devices include, for example, one or more memory IC devices 504, such as double-data rate dynamic random access memory (DDR DRAM) devices. Alternatively or additionally, the first set of IC devices (also) includes a system-on-chip (SoC) IC device 506 or an embedded multimedia card (eMMC) IC device 508.

Each IC device may electrically connect to the PCB 104 using solder connections that result from surface-mount (SMT) manufacturing techniques. In general, the first set of IC devices populating the first surface 502 of the PCB 104, when operating, may contribute to a heat load (e.g., the internal heat load 108 of FIG. 1) within a mesh network device (e.g., the mesh network device 102 of FIG. 1). In some instances, an electromagnetic interference (EMI) shield 510 may surround one or more planar regions 512 of the first surface 502 containing one or more the first set of IC devices.

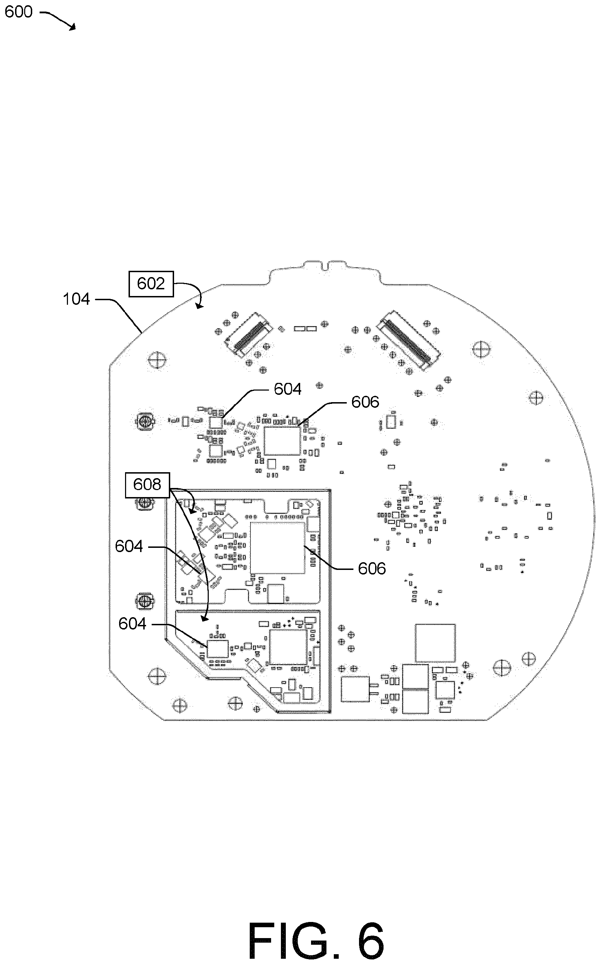

FIG. 6 illustrates a bottom plan view 600 of an example PCB that may be included in a mesh network device (*e.g.,* the PCB 104 of the mesh network device 102 of FIG. 1). A second surface of the PCB 104 (*e.g.,* a second surface 602 that is opposite the first surface 502 of FIG. 5) may be populated with a second set of IC devices. The second set of IC devices may include, for example, one or more front end module (FEM) IC devices 604 (*e.g.,* 2.4 Gigahertz (GHz) FEM, 5 GHz FEM, Thread FEM) and one or more radio frequency (RF) IC devices 606 (*e.g.,* 2.4 GHz RF, 5 GHz RF) that may be associated with wireless communications of a wireless local area network (WLAN).

In general, the second set of IC devices populating the second surface 602 of the PCB 104, when operating, may contribute to a heat load (*e.g.,* the internal heat load 108 of FIG. 1) within a mesh network device (*e.g.,* the mesh network device 102 of FIG. 1). In some instances, another electromagnetic interference (EMI) shield may surround one or more planar regions 608 of the second surface 602 containing or more of the second set of IC devices.

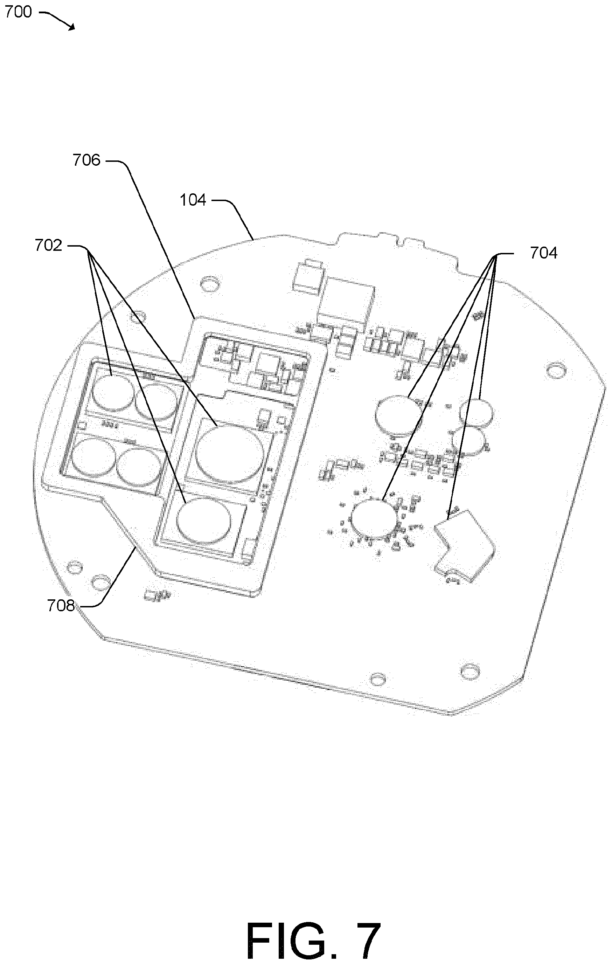

FIG. 7 illustrates a top isometric view 700 of an example arrangement of TIMs that may be included in a mesh network device. The TIMs, as arranged, may transfer heat from IC devices populating the PCB 104 to a heat sink (*e.g.,* the heat sink 112 of FIG. 1).

A first set of TIMs 702 may thermally couple a first set of IC devices populating a first surface of the PCB 104 (*e.g.,* the one or more memory IC devices 504, the SoC IC device 506, and the eMMC IC device 508 populating the first surface 502 of FIG. 5) to respective pedestals that are part of the heat sink (*e.g.,* a subset of the one or more pedestal(s) 304 of FIG. 3). The first set of TIMs 702 may be in directed thermal contact with the first set of IC devices.

In general, the first set of TIMs 702 may be positioned between the first set of IC devices and respective pedestals that are part of the heat sink. Furthermore, the first set of TIMs 702 may use a thermal-conduction heat-transfer mechanism to transfer heat from the first set of IC devices to the heat sink. In some instances, an EMI shield 708 may surround the first set of IC devices. In such instances, a thermally conductive foam may be located between the EMI shield 708 and the heat sink.

A second set of TIMs 704 may thermally couple, indirectly, a second set of IC devices, populating a second surface of the PCB 104 (*e.g.,* the one or more FEM IC devices 604, and the one or more RF IC devices 606, populating the second surface 602 of FIG. 6), to other respective pedestals that are part of the heat sink (e.g., another subset of the one or more pedestal(s) 304 of FIG. 3). In this instance, and as opposed to being in direct physical contact with the second set of IC devices, the second set of TIMs 704 may be in direct physical contact with the surface of the PCB 104 (e.g., the first surface 502 of FIG. 5), which is opposite from the surface to which the other IC devices are mounted (*e.g.,* the second surface 602 of FIG. 6) and proximate (*e.g.,* located coaxially, respectively) to the second set of IC devices.

In general, the second set of TIMs 704 may be positioned between the surface of the PCB 104 and the other respective pedestals that are part of the heat sink, proximate to multiple other IC devices. Furthermore, the second set of TIMs 704 may use a thermal-conduction heat-transfer mechanism to transfer heat from the multiple other IC devices to the heat sink.

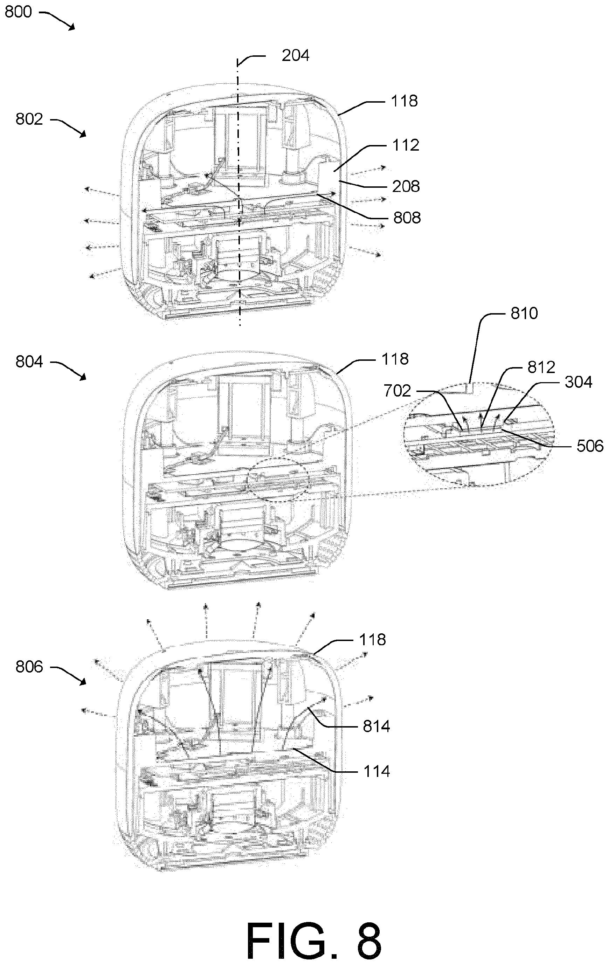

FIG. 8 illustrates example details 800 of heat-transfer paths within the example mesh network device 102. The example details 800 include several instances of a sectional view of the mesh network device 102, including instances 802, 804, and 806. The top illustration of FIG. 8 illustrates a first heat-transfer path 808 that transfers heat (e.g., a portion of the internal heat load 108 originating from multiple IC devices populating the PCB 104 and/or the speaker module 106 of FIG. 1) through the heat sink 112. The heat sink 112 may then, using convection, conduction, and/or radiation heat-transfer mechanisms, transfer the heat through the one or more fin regions 208 to the housing component 118 in a direction that is generally orthogonal to the central axis 204 of the heat sink 112. The housing component 118 may then, using convection and/or radiation heat-transfer mechanisms, transfer heat received through the first heat-transfer path 802 to the surrounding environment.

The middle illustration of FIG. 8 illustrates an enlarged view 810 of the second instance 804 within the example mesh network device 102. As illustrated, the second instance includes a second heat transfer path 812. As part of the second heat transfer path 812, a TIM of the first set of TIM(s) 702 uses thermal conduction to transfer heat from the SoC IC device 506 to one of the one or more pedestal(s) 304 (*e.g.,* a corresponding respective pedestal of the one or more pedestal(s) 304). Heat transferred through the second heat-transfer path 812 may "join" with heat of the first heat-transfer path 808 to be transferred through the housing component 118 to the surrounding environment.

The bottom illustration of FIG. 8 illustrates a third instance 806. The third instance 806 includes a third heat-transfer path 814 that may use convection and/or radiation heat-transfer mechanisms to transfer heat (*e.g.,* another portion of the internal heat load 108 originating from multiple IC devices populating the PCB 104 and/or the speaker module 106 of FIG. 1) to the housing component 118. Then, the housing component 118 may, using convection and/or radiation heat-transfer mechanisms, transfer heat received through the third heat-transfer path 814 to the surrounding environment.

Although techniques using and apparatuses for a passive thermal-control system of a mesh network device and associated mesh network devices are described, it is to be understood that the subject of the appended claims is not necessarily limited to the specific features or methods described. Rather, the specific features and methods are disclosed as example ways in which a thermal-control system of a mesh network device and associated mesh network devices can be implemented.

**Claims**

1. An apparatus (102) comprising:

   one or more integrated circuit devices (504, 506, 508);
   a speaker module (106) comprising a base (404) and a speaker driver (406); and
   a passive thermal-control system (110) to conduct heat generated by the speaker module (106) and by the one or more integrated circuit devices (504, 506, 508) to a housing component (118) of the apparatus (102) for external dissipation, the passive thermal-control system (110) comprising:

   a heat sink (112), the heat sink generally cylindrical and centered about a central axis (204), the heat sink (112) including an interior disk-like body (202) that is substantially orthogonal to the central axis (204) and thermally coupled to at least one of the one or more integrated circuit devices (504, 506, 508);
   a first heat spreader (114), the first heat spreader generally planar and attached to a first surface (206) of the interior disk-like body (202); and
   a second heat spreader (116), the second heat spreader generally planar and attached to a surface (408) of the speaker module (106) that is substantially orthogonal to the central axis (204) and faces a second surface (302) of the interior disk-like body that is opposite the first surface (206) of the interior disk-like body (202),

   wherein the second heat spreader (116) is attached to the base (404) of the speaker module (106) and is located between the surface (408) of the speaker module (106) and a magnet of the speaker driver (406).

2. The apparatus of claim 1, wherein the heat sink (112) includes one or more fin regions (208) that extend from a perimeter of the disk-like body (202) of the heat sink (112) in one or more directions that are substantially parallel to the central axis (204), the each of the one or more fin regions (208) proximate an inner surface of the housing (118).

3. The apparatus of claim 2, further comprising: an electromagnetic interference shield (510) surrounding the one or more integrated circuit devices (504, 506, 508), and a thermally conductive foam material that thermally couples the electromagnetic interference shield (510) to the heat sink (112).

4. The apparatus of claim 3, wherein the heat sink (112) includes a die-cast aluminum material or a magnesium material.

5. The apparatus of claim 3 or 4, wherein the first heat spreader (114) or the second heat spreader (116) includes a graphite material.

6. The apparatus of any one of the preceding claims, further comprising a printed circuit board (104) to which the one or more integrated circuit devices (504, 506, 508) are mounted, wherein the second surface (302) of the disk-like body (202) faces the printed circuit board (104).

7. The apparatus of any one of the preceding claims, wherein one or more respective thermal interface materials located between the one or more integrated circuit devices (504, 506, 508) and the heat sink (112) thermally couple the one or more integrated circuit devices (504, 506, 508) to the heat sink (112).

8. The apparatus of any one of the preceding claims in combination with claim 2, wherein the disk-like body (202) of the heat sink (112) extends radially from the central axis (204) and defines the perimeter, the disk-like body (202) having:
   one or more pedestals (304) extending from the second surface (302); and
   wherein each of the one or more fin regions (208) has an interior surface (210) and an opposing exterior surface (212), the interior surface (210) facing toward the central axis (204).

9. The apparatus of claim 8, wherein the one or more integrated circuit devices (504, 506, 508) include a system-on-chip integrated circuit device (506) and the apparatus (102) further includes a first thermal interface material that is located between a first pedestal of the one or more pedestals (304) and the system-on-chip integrated circuit device (506).

**10.** The apparatus of claim 9, wherein the one or more integrated circuit devices (504, 506, 508) include a memory integrated circuit device (504) and the apparatus (102) further includes a second thermal interface material that is located between a second pedestal of the one or more pedestals (304) and the memory integrated circuit device (504).

**11.** The apparatus of claims 9 and 10 in combination with claims 3 and 6, wherein the system-on-chip integrated circuit device (506) and the memory integrated circuit device (504)
occupy a region (512) of the printed circuit board (104) that is generally planar and surrounded by the electromagnetic interference shield (510).

**12.** The apparatus of claim 11, further including a thermally conductive foam material located between the electromagnetic interference shield (510) and the body (202).

**13.** The apparatus of claim 12, wherein the printed circuit board (104) is located between the disk-like body (202) of the heat sink (112) and the speaker module (106).

**14.** The apparatus of any one of claims 8 to 13, wherein the heat sink (112) includes a mount that attaches an antenna to the heat sink (112).

**Patentansprüche**

**1.** Vorrichtung (102), umfassend:

eine oder mehrere integrierte Schaltungsvorrichtungen (504, 506, 508) ;
ein Lautsprechermodul (106), umfassend eine Basis (404) und einen Lautsprechertreiber (406); und
ein passives thermisches Steuerungssystem (110), um Wärme, die durch das Lautsprechermodul (106) und durch die eine oder mehreren integrierten Schaltungsvorrichtungen (504, 506, 508) erzeugt wird, zu einer Gehäusekomponente (118) der Vorrichtung (102) für externe Ableitung zu leiten, wobei das passive thermische Steuerungssystem (110) Folgendes umfasst:

eine Wärmesenke (112), wobei die Wärmesenke im Allgemeinen zylindrisch und um eine Mittelachse (204) zentriert ist, wobei die Wärmesenke (112) einen inneren scheibenförmigen Körper (202) beinhaltet, der im Wesentlichen orthogonal zu der Mittelachse (204) und thermisch mit mindestens einer der einen oder der mehreren integrierten Schaltungsvorrichtungen (504, 506, 508) gekoppelt ist;
einen ersten Wärmeverteiler (114), wobei der erste Wärmeverteiler im Allgemeinen planar und an einer ersten Oberfläche (206) des inneren scheibenförmigen Körpers (202) befestigt ist; und
einen zweiten Wärmeverteiler (116), wobei der zweite Wärmeverteiler im Allgemeinen planar und an einer Oberfläche (408) des Lautsprechermoduls (106) befestigt ist, die im Wesentlichen orthogonal zu der Mittelachse (204) ist und einer zweiten Oberfläche (302) des inneren scheibenförmigen Körpers zugewandt ist, die der ersten Oberfläche (206) des inneren scheibenförmigen Körpers (202) gegenüberliegt,
wobei der zweite Wärmeverteiler (116) an der Basis (404) des Lautsprechermoduls (106) befestigt ist und sich zwischen der Oberfläche (408) des Lautsprechermoduls (106) und einem Magneten des Lautsprechertreibers (406) befindet.

**2.** Vorrichtung nach Anspruch 1, wobei die Wärmesenke (112) einen oder mehrere Finnenbereiche (208) beinhaltet, die sich von einem Umfang des scheibenförmigen Körpers (202) der Wärmesenke (112) in einer oder mehreren Richtungen erstrecken, die im Wesentlichen parallel zu der Mittelachse (204) sind, wobei jeder des einen oder der mehreren Finnenbereiche (208) nahe einer Innenfläche des Gehäuses (118) ist.

**3.** Vorrichtung nach Anspruch 2, ferner umfassend: eine Abschirmung (510) gegen elektromagnetische Interferenz, die die eine oder mehreren integrierten Schaltungsvorrichtungen (504, 506, 508) umgibt, und ein wärmeleitendes Schaummaterial, das die Abschirmung (510) gegen elektromagnetische Interferenz thermisch mit der Wärmesenke (112) koppelt.

**4.** Vorrichtung nach Anspruch 3, wobei die Wärmesenke (112) ein Aluminiumdruckgussmaterial oder ein Magnesiummaterial beinhaltet.

**5.** Vorrichtung nach Anspruch 3 oder 4, wobei der erste Wärmeverteiler (114) oder der zweite Wärmeverteiler (116) ein Grafitmaterial beinhaltet.

6. Vorrichtung nach einem der vorhergehenden Ansprüche, ferner umfassend eine gedruckte Leiterplatte (104), auf der die eine oder mehreren integrierten Schaltungsvorrichtungen (504, 506, 508) montiert sind, wobei die zweite Oberfläche (302) des scheibenförmigen Körpers (202) der Leiterplatte (104) zugewandt ist.

7. Vorrichtung nach einem der vorhergehenden Ansprüche, wobei ein oder mehrere jeweilige Wärmeleitmaterialien, die sich zwischen der einen oder den mehreren integrierten Schaltungsvorrichtungen (504, 506, 508) und der Wärmesenke (112) befinden, die eine oder die mehreren integrierten Schaltungsvorrichtungen (504, 506, 508) thermisch mit der Wärmesenke (112) koppeln.

8. Vorrichtung nach einem der vorhergehenden Ansprüche in Kombination mit Anspruch 2, wobei sich der scheibenförmige Körper (202) der Wärmesenke (112) radial von der Mittelachse (204) erstreckt und den Umfang definiert, wobei der scheibenförmige Körper (202) Folgendes aufweist:

einen oder mehrere Sockel (304), die sich von der zweiten Oberfläche (302) erstrecken; und
wobei jeder des einen oder der mehreren Finnenbereiche (208) eine Innenfläche (210) und eine gegenüberliegende Außenfläche (212) aufweist, wobei die Innenfläche (210) der Mittelachse (204) zugewandt ist.

9. Vorrichtung nach Anspruch 8, wobei die eine oder die mehreren integrierten Schaltungsvorrichtungen (504, 506, 508) eine systemchipintegrierte Schaltungsvorrichtung (506) beinhalten und die Vorrichtung (102) ferner ein erstes Wärmeleitmaterial beinhaltet, das sich zwischen einem ersten Sockel des einen oder der mehreren Sockel (304) und der systemchipintegrierten Schaltungsvorrichtung (506) befindet.

10. Vorrichtung nach Anspruch 9, wobei die eine oder mehreren integrierten Schaltungsvorrichtungen (504, 506, 508) eine speicherintegrierte Schaltungsvorrichtung (504) beinhalten und die Vorrichtung (102) ferner ein zweites Wärmeleitmaterial beinhaltet, das sich zwischen einem zweiten Sockel des einen oder der mehreren Sockel (304) und der speicherintegrierten Schaltungsvorrichtung (504) befindet.

11. Vorrichtung nach Anspruch 9 und 10 in Kombination mit Anspruch 3 und 6, wobei die systemchipintegrierte Schaltkreisvorrichtung (506) und die speicherintegrierte Schaltkreisvorrichtung (504)
einen Bereich (512) der gedruckten Leiterplatte (104) einnehmen, der im Allgemeinen planar und von der Abschirmung (510) gegen elektromagnetische Interferenz umgeben ist.

12. Vorrichtung nach Anspruch 11, ferner beinhaltend ein wärmeleitendes Schaummaterial, das sich zwischen der Abschirmung (510) gegen elektromagnetische Interferenz und dem Körper (202) befindet.

13. Vorrichtung nach Anspruch 12, wobei sich die Leiterplatte (104) zwischen dem scheibenförmigen Körper (202) der Wärmesenke (112) und dem Lautsprechermodul (106) befindet.

14. Vorrichtung nach einem der Ansprüche 8 bis 13, wobei die Wärmesenke (112) eine Halterung beinhaltet, die eine Antenne an der Wärmesenke (112) befestigt.

## Revendications

1. Appareil (102), comprenant :

un ou plusieurs dispositifs à circuit intégré (504, 506, 508) ;
un module de haut-parleur (106) comprenant une base (404) et un haut-parleur (406) ; et
un système de contrôle thermique passif (110) pour conduire la chaleur générée par le module de haut-parleur (106) et par les un ou plusieurs dispositifs à circuit intégré (504, 506, 508) vers un composant de boîtier (118) de l'appareil (102) pour dissipation externe, le système de contrôle thermique passif (110) comprenant :

un dissipateur thermique (112), le dissipateur thermique étant généralement cylindrique et centré autour d'un axe central (204), le dissipateur thermique (112) comportant un corps intérieur en forme de disque (202) qui est sensiblement orthogonal à l'axe central (204) et couplé thermiquement à au moins l'un des un ou plusieurs dispositifs à circuit intégré (504, 506, 508) ;

un premier dissipateur thermique (114), le premier dissipateur thermique étant généralement plan et fixé à une première surface (206) du corps intérieur en forme de disque (202) ; et

un second dissipateur thermique (116), le second dissipateur thermique étant généralement plan et fixé à une surface (408) du module de haut-parleur (106) qui est sensiblement orthogonale à l'axe central (204) et fait face à une seconde surface (302) du corps intérieur en forme de disque qui est opposé à la première surface (206) du corps intérieur en forme de disque (202),

dans lequel le second dissipateur thermique (116) est fixé à la base (404) du module de haut-parleur (106) et est situé entre la surface (408) du module de haut-parleur (106) et un aimant du haut-parleur (406).

2. Appareil selon la revendication 1, dans lequel le dissipateur thermique (112) comporte une ou plusieurs régions d'ailettes (208) qui se prolongent à partir d'un périmètre du corps en forme de disque (202) du dissipateur thermique (112) dans une ou plusieurs directions qui sont sensiblement parallèles à l'axe central (204), chacune des une ou plusieurs régions d'ailettes (208) est proche d'une surface interne du boîtier (118).

3. Appareil selon la revendication 2, comprenant également : un bouclier contre les interférences électromagnétiques (510) entourant les un ou plusieurs dispositifs à circuit intégré (504, 506, 508), et un matériau en mousse thermiquement conducteur qui couple thermiquement le bouclier contre les interférences électromagnétiques (510) au dissipateur thermique (112) .

4. Appareil selon la revendication 3, dans lequel le dissipateur thermique (112) comporte un matériau en aluminium moulé sous pression ou un matériau en magnésium.

5. Appareil selon la revendication 3 ou 4, dans lequel le premier dissipateur thermique (114) ou le second dissipateur thermique (116) comporte un matériau en graphite.

6. Appareil selon l'une quelconque des revendications précédentes, comprenant également une carte de circuit imprimé (104) sur laquelle les un ou plusieurs dispositifs à circuit intégré (504, 506, 508) sont montés, dans lequel la seconde surface (302) du corps en forme de disque (202) fait face à la carte de circuit imprimé (104).

7. Appareil selon l'une quelconque des revendications précédentes, dans lequel un ou plusieurs matériaux d'interface thermique respectifs situés entre les un ou plusieurs dispositifs à circuit intégré (504, 506, 508) et le dissipateur thermique (112) couplent thermiquement les un ou plusieurs dispositifs à circuit intégré (504, 506, 508) au dissipateur thermique (112).

8. Appareil selon l'une quelconque des revendications précédentes en combinaison avec la revendication 2, dans lequel le corps en forme de disque (202) du dissipateur thermique (112) se prolonge radialement à partir de l'axe central (204) et définit le périmètre, le corps en forme de disque (202) ayant :

un ou plusieurs socles (304) se prolongeant à partir de la seconde surface (302) ; et
dans lequel chacune des une ou plusieurs régions d'ailettes (208) a une surface intérieure (210) et une surface extérieure opposée (212), la surface intérieure (210) étant tournée vers l'axe central (204).

9. Appareil selon la revendication 8, dans lequel les un ou plusieurs dispositifs à circuit intégré (504, 506, 508) comportent un dispositif à circuit intégré système sur puce (506) et l'appareil (102) comporte également un premier matériau d'interface thermique qui est situé entre un premier socle des un ou plusieurs socles (304) et le dispositif à circuit intégré système sur puce (506).

10. Appareil selon la revendication 9, dans lequel les un ou plusieurs dispositifs à circuit intégré (504, 506, 508) comportent un dispositif à circuit intégré sur mémoire (504) et l'appareil (102) comporte également un second matériau d'interface thermique qui est situé entre un second socle des un ou plusieurs socles (304) et le dispositif à circuit intégré sur mémoire (504).

11. Appareil selon les revendications 9 et 10 en combinaison avec les revendications 3 et 6, dans lequel le dispositif à circuit intégré système sur puce (506) et le dispositif à circuit intégré sur mémoire (504) occupent une région (512) de la carte de circuit imprimé (104) qui est généralement plane et entourée par le bouclier contre les interférences électromagnétiques (510).

12. Appareil selon la revendication 11, comportant également un matériau en mousse thermoconducteur situé entre le bouclier contre les interférences électromagnétiques (510) et le corps (202) .

13. Appareil selon la revendication 12, dans lequel la carte de circuit imprimé (104) est située entre le corps en forme de disque (202) du dissipateur thermique (112) et le module de haut-parleur (106).

14. Appareil selon l'une quelconque des revendications 8 à 13, dans lequel le dissipateur thermique (112) comporte un support qui fixe une antenne au dissipateur thermique (112).

FIG. 1

FIG. 2

300

204

304

112

302

202

# FIG. 3

FIG. 4

# FIG. 5

FIG. 6

700

706

104

702

704

708

# FIG. 7

FIG. 8

**EP 3 806 492 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2015382448 A1

- US 2019104640 A1